Europäisches Patentamt

European Patent Office

Office européen des brevets

(19)

(11) Publication number: 0 235 925
A2

# (12) EUROPEAN PATENT APPLICATION

(21) Application number: 87300711.6

(22) Date of filing: 28.01.87

(51) Int. Cl.⁴: **H05K 7/02** , H05K 13/04

(30) Priority: 03.03.86 US 835199

(43) Date of publication of application:
**09.09.87 Bulletin 87/37**

(84) Designated Contracting States:
**DE FR GB IT**

(71) Applicant: **GENERAL MOTORS CORPORATION
General Motors Building 3044 West Grand
Boulevard
Detroit Michigan 48202(US)**

(72) Inventor: **Jung, James Eugene
6478 Hillcrest Drive
Westfield Indiana 46074(US)**
Inventor: **Koors, Mark Anthony
3221 West 50 South
Kokomo Indiana 46902(US)**
Inventor: **Lutz, Phillip A.
2008 Corvette Drive
Kokomo Indiana 46902(US)**

(74) Representative: **Haines, Arthur Donald et al
Patent Section (F6) Vauxhall Motors Limited
P.O. Box 3 Kimpton Road
Luton, Beds. LU2 OSY(GB)**

(54) Surface-mountable package for encapsulated tap-automated-bonded integrated circuit modules.

(57) A surface-mountable package formed by nesting an encapsulated tape-automated-bonded integrated circuit module (I0) in between two synthetic plastics rings (30,32) snapped together.

Fig.2

EP 0 235 925 A2

## SURFACE-MOUNTABLE PACKAGE FOR ENCAPSULATED TAPE-AUTOMATED-BONDED INTEGRATED CIRCUIT MODULES

### Field of the invention

The present invention generally relates to the packaging of an encapsulated tape-automated-bonded integrated circuit module and, more particularly, is concerned with a specific package for an encapsulated tape-automated-bonded integrated circuit module.

### Background of the invention

In recent years, techniques of using a tape-automated-bonding process (generally referred to as the TAB process) to package integrated circuit chips have been developed. The TAB process replaces other lead-frame wire bonding methods that are currently used in packaging integrated circuit chips. In one form of the TAB process, an integrated circuit chip is directly bonded to a foil-type lead frame tape that is usually rolled in about 0.08 mm in thickness. The inner ends of the leads that were etched into the foil tape are bonded to solder bumps on the integrated circuit chips by a thermal compression method.

The integrated circuit chip is then encapsulated in synthetic plastics material in an injection moulding process leaving the outer ends of the leads exposed to the outside of the integrated circuit. The encapsulated integrated circuit and the exposed leads can then be excised from the tape for connection to a circuit board. The term "an integrated circuit module" is used throughout this specification to describe an encapsulated TAB integrated circuit and its exposed leads.

In an encapsulated TAB integrated circuit module, the integrated circuit chip itself is well protected by the encapsulating synthetic plastics material. However, the leads, which are formed of tin-plated copper foil, are exposed for necessary connection to a circuit board. The dimensions of these leads, which are approximately 0.3 mm wide, 0.08 mm thick, and 5 mm long, make them very fragile and susceptible to damage during manufacturing and assembly. The fact that these leads are closely spaced together and in close proximity to the encapsulated chip make them almost impossible to repair once they are damaged.

It is therefore an object of the present invention to provide an integrated circuit package for surface mounting wherein the packaged leads to the integrated circuit chip are protected from deformation and damage during the manufacturing and assembly process.

It is another object of the present invention to provide an integrated circuit package for surface mounting wherein the leads to the integrated circuit chip can be formed into desirable shapes to be connected to a circuit board in a later process and can be protected from deformation and damage during such a process.

### Summary of the invention

The present invention involves a surface-mountable integrated circuit package formed by nesting an encapsulated TAB integrated circuit module between two protective collars and snapping these collars together. We may refer to an integrated circuit package as an integrated circuit carrier. The protective collars may also be referred to as rings or protective members.

In the present invention, integrated circuit chips are first bonded by a TAB process (tape-automated-bonding) and then encapsulated in synthetic plastics material to form an integrated circuit module. In the next processing step, this module is excised from the copper foil tape in order to be tested or mounted to a circuit board. These integrated circuit packages have very closely spaced external leads which may be subjected to unwanted deformation and damage before they are used on a circuit board. In the present invention, a lead-forming protective member is affixed to an integrated circuit module over the external leads and forms the leads to a desirable shape by a specially designed contoured end on the protective member. The protective member has recessed areas on a contoured surface thereof to house the external leads and to keep them separated from one another. The external leads contact at least one edge of the contoured surface and closely wrap around the adjacent end of the protective member so that the external leads are conformed to the shape of the contoured end of the protective member.

The process of affixing the lead-forming and protective member to an integrated circuit module can be performed in either one of two ways. First, a lower forming anvil having a recessed cavity may be used as a forming die so that, when a protective member is mounted on the integrated circuit module and pushed down into the forming die, the ends of the external leads are wrapped around the contoured surface of the adjacent end of the protective member. An integrated circuit module assembly thus formed may be soldered down as a surface-mountable device. The lead-forming and protective member may then be removed from the integrated circuit module, if desired, so that the soldered leads may be inspected and, if needed, repaired.

In an alternative method, the lower forming anvil is replaced by a second lead-forming and protective member of a size larger than the first member in such a way that, when the first protective member is pushed down onto an integrated circuit module, the first member will nest into the second member while simultaneously locking the module in place between the two members. The inner surface of the second protective member acts as a forming die so that the ends of the external leads can be wrapped around on the forming edge of the first protective member. After the first protective member, the second protective member and the module are locked together into an integrated circuit module assembly, that assembly can be soldered to a circuit board as a surface-mountable device. Additionally, both the first member and the second member may be slipped off the top of the integrated circuit module after mounting the module to a circuit board, if desired, so as to expose soldered external leads of the module so that they can be inspected and/or repaired. The first protective member can be conveniently described as a locating ring and the second protective member can be conveniently described as a retainer ring. Both members are injection-moulded from a thermoplastics material.

Brief Description of Drawings

Other objects, features and advantages of the present invention will become apparent upon consideration of the specification and the accompanying drawings, in which:

FIGURE 1 is a perspective view of an integrated circuit module.

FIGURE 2 is a perspective cutaway view of an encapsulated TAB integrated circuit module having an inner protective member and an outer protective member installed thereon. The module is positioned on a circuit board.

FIGURE 3 is a schematic view showing a protective ring (locating ring) positioned over an integrated circuit module and a lower die.

FIGURE 4 is a schematic view showing the integrated circuit module being pushed down into the lower die by the protective ring in a forming position for the external lead ends.

FIGURE 5 is a schematic view of the integrated circuit module with the protective ring mounted thereon.

FIGURE 6 is a schematic view showing the integrated circuit module and its formed external leads after the protective ring has been removed.

FIGURE 7 is a schematic view showing an integrated circuit module positioned between an outer protective ring and an inner protective ring.

FIGURE 8 is a schematic view showing the outer protective ring and the inner protective ring in a snapped-together position with the integrated circuit module nested therein.

FIGURE 9 is an elevational view of the outer protective ring and the inner protective ring in a snapped-together position having the integrated circuit module nested therebetween.

FIGURE 10 is a schematic view showing the integrated circuit module with the external leads in a formed position after the inner and the outer protective rings are removed.

FIGURE 11 shows a top plan view of the inner protective ring.

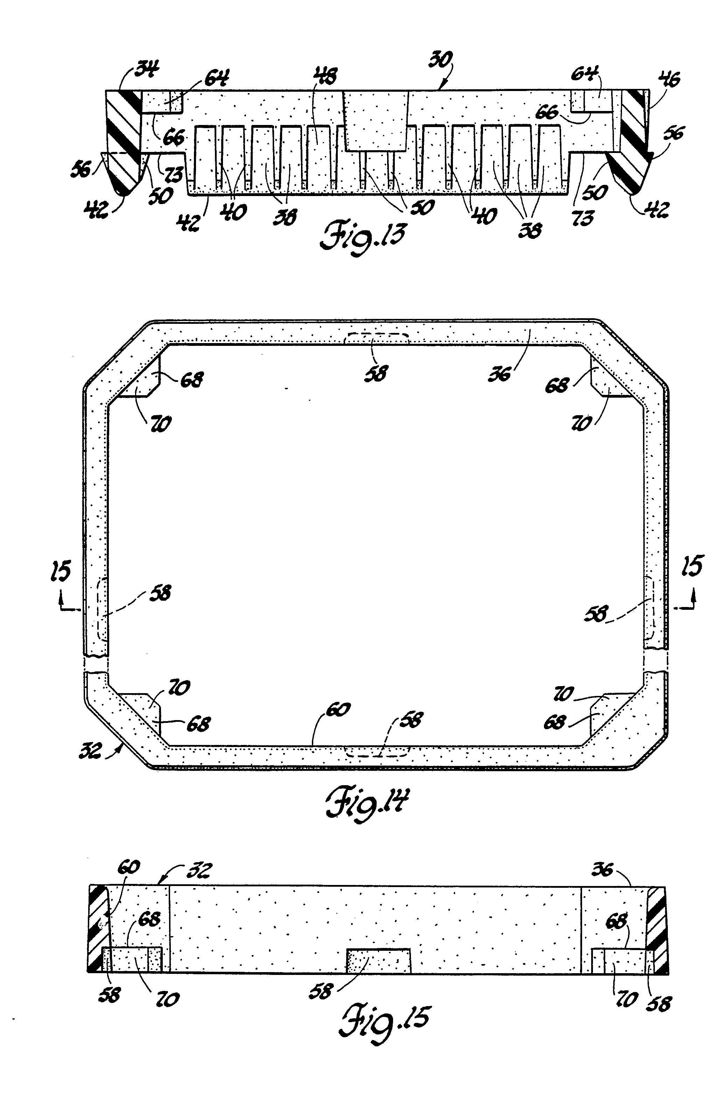

FIGURE 12 is a bottom plan view of the inner protective ring.

FIGURE 13 is a cross-sectional view taken substantially along line 13-13 in FIGURE 11.

FIGURE 14 is a top plan view of the outer protective ring (retainer ring).

FIGURE 15 is a cross-sectional view taken along line 15-15 in FIGURE 14.

Two preferred embodiments are hereinafter described, in which an integrated circuit package is formed by snapping either one or two protective rings onto an integrated circuit module.

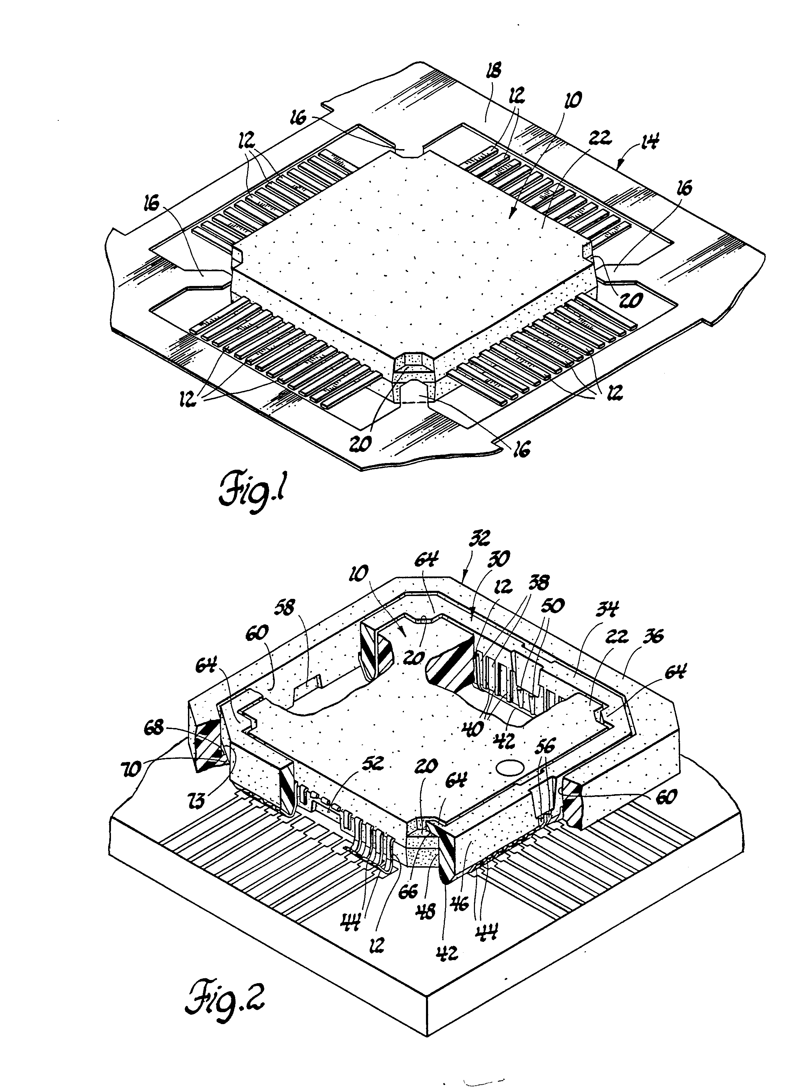

Referring initially to FIGURE 1, an encapsulated TAB (tape-automated-bonding) integrated circuit module 10 is shown, which includes external leads 12 formed from copper foil tape 14. The external leads 12 of the integrated circuit module have been severed from the copper foil tape 14 except at corner tabs 16. A surface 18 of the copper foil tape 14 is coated with tin. At each corner of the integrated circuit module 10, a recess 20 is formed in a top surface 22 of the module. Note that the external leads 12 are closely spaced together and in close proximity to the body portion of the encapsulated TAB module 10. The corner tabs 16 are normally dummy leads which are not connected to the circuits of the integrated circuit chip. The corner tabs 16 are used to physically support the module 10 so that testing or other processing steps such as encapsulation in synthetic plastics material can be performed on the module.

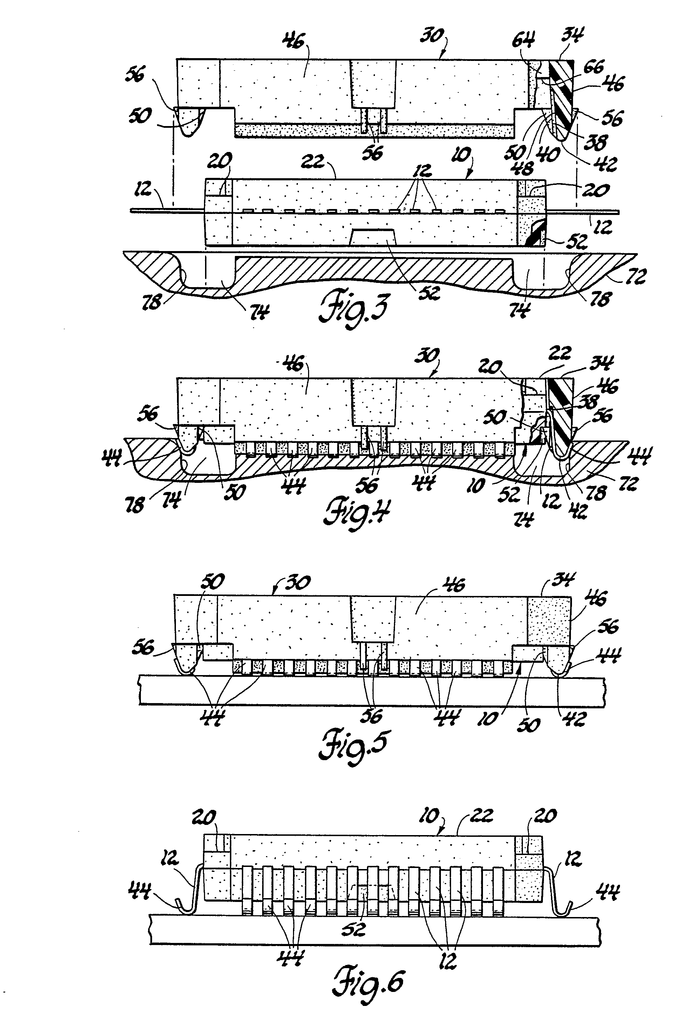

FIGURE 2 shows the same encapsulated TAB integrated circuit module 10 having a flexible synthetic plastics inner protective ring (locating ring) 30 and a flexible synthetic plastics outer protective ring (retainer ring) 32 mounted thereon. Note that a top surface 34 of the locating ring 30 and a top surface 36 of the retainer ring 32 are substantially flush with the top surface 22 of the module 10 after the three parts are snapped together in an assembled position. On an inner surface 48 of locating ring 30, a series of recessed areas 38 are provided to house external leads 12 so that they are mutually separated by ledges 40. The external leads 12 contact a contoured end 42 of locating ring 30. Note that ends 44 of the external leads 12 are wrapped around the contoured end 42 of locating ring 30 to contact an outer surface 46 of locating ring 30 when retainer ring 32 is mounted on the outside of locating ring 30. The recessed areas 38 on the inner surface 48 of the locating ring 30 keeps the ends 44 of the external leads at a predetermined distance from each other so that they are separated from one another. A built-in latch 50 centrally located on the inner surface 48 of locating ring 30 latches onto a recessed area 52 also centrally located on TAB module 10 at each of the four sides. The locking engagement between latches 50 and recessed areas 52 prevent the TAB module 10 and the locating ring 30 from easy separation from one another. However, the two parts can still be separated when desired by using a suitable amount of force to temporarily bend the flexible plastics parts, and release the latches. This occurs in a situation where external leads 12 must be exposed so that they can be inspected after being soldered down on to a circuit board.

In FIGURE 2, built-in latches 56 centrally located on the outer surface of locating ring 30 provide a locking action between locating ring 30 and retainer ring 32 by engaging corresponding recessed areas 58 centrally located on each side of an inner surface 60 of retainer ring 32. At each corner of locating ring 30, a stop 64 is provided so that a surface 66 of the stop engages a corresponding surface of the recess 22 located at each corner of the TAB module 10. Stops 64 at each corner fix the position of locating ring 30 relative to the position of TAB module 10. It should be noted that while latches 50 provide locking action between locating ring 30 and TAB integrated circuit module 10, they also function as ledges such as 40 for the separation of the external leads. It should also be noted that while the specific embodiment shows latches 50 centrally located on each side of locating ring 30, they may be suitably located anywhere on the inner surface 48 of locating ring 30 and function equally well. For instance, locating rings having the latches at each corner of the ring have been used and satisfactory results obtained.

FIGURE 2 illustrates a first preferred embodiment in which both an inner protective ring and an outer protective ring are used. In a second preferred embodiment, a forming anvil instead of the outer protective ring is used to form the ends of the external leads into desirable shapes. A schematic of this second preferred embodiment in a partially cutaway view is shown in FIGURE 3. A forming anvil 72 having a cavity 74 is used in place of retainer ring 32 shown in FIGURE 2. When locating ring 30 is pushed down on TAB integrated circuit module 10 into the forming anvil 72, the external leads 12 are wrapped around the inner surface 48, the contoured end 42 and the outer surface 46 of locating ring 30. An inner surface 78 of forming anvil 72 helps to shape the external leads 12 into a predetermined shape.

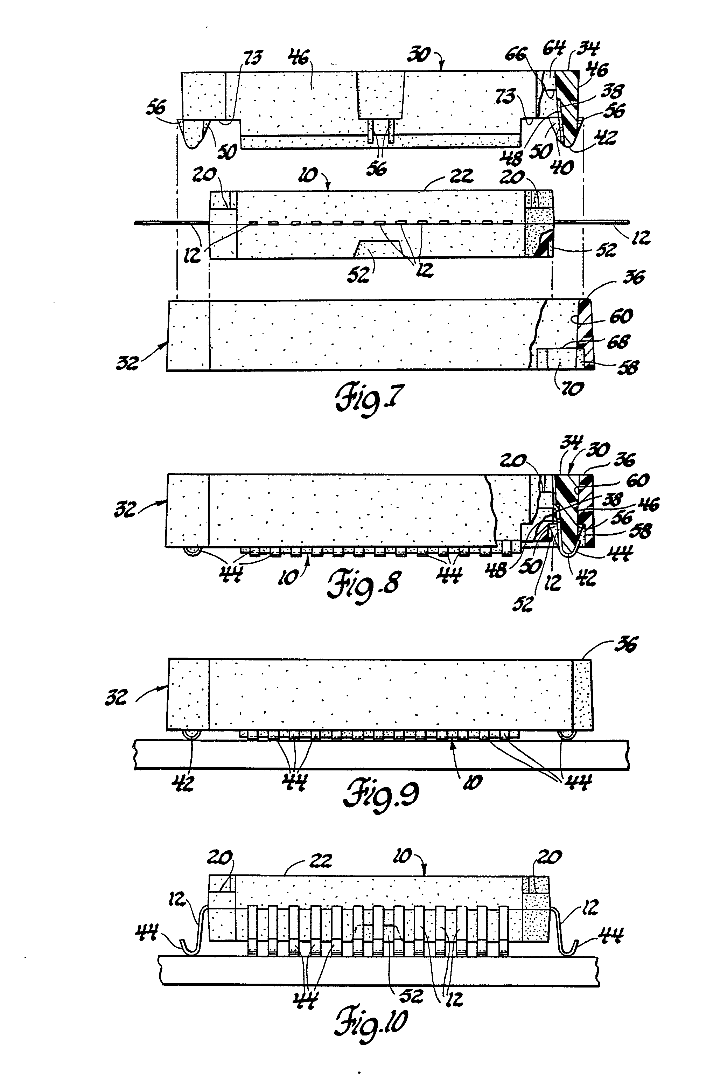

FIGURE 4 is a schematic view showing the locating ring 30, the TAB integrated circuit module 10, and the forming anvil 72 in a forming position. Note that ends 44 of external leads 12 are wrapped around the contoured end 42 of the locating ring when the external leads 12 are pushed into forming die 74. FIGURE 5 shows an assembly of locating ring 30 and TAB integrated circuit module 10 after removal from forming anvil 72. The locating ring 30 may optionally be removed from TAB integrated circuit module 10, after soldering the external leads 12 of the module 10 to a circuit board, so as to expose the external leads 12 so that inspection and/or repair of any connections can be performed. This is shown in FIGURE 6.

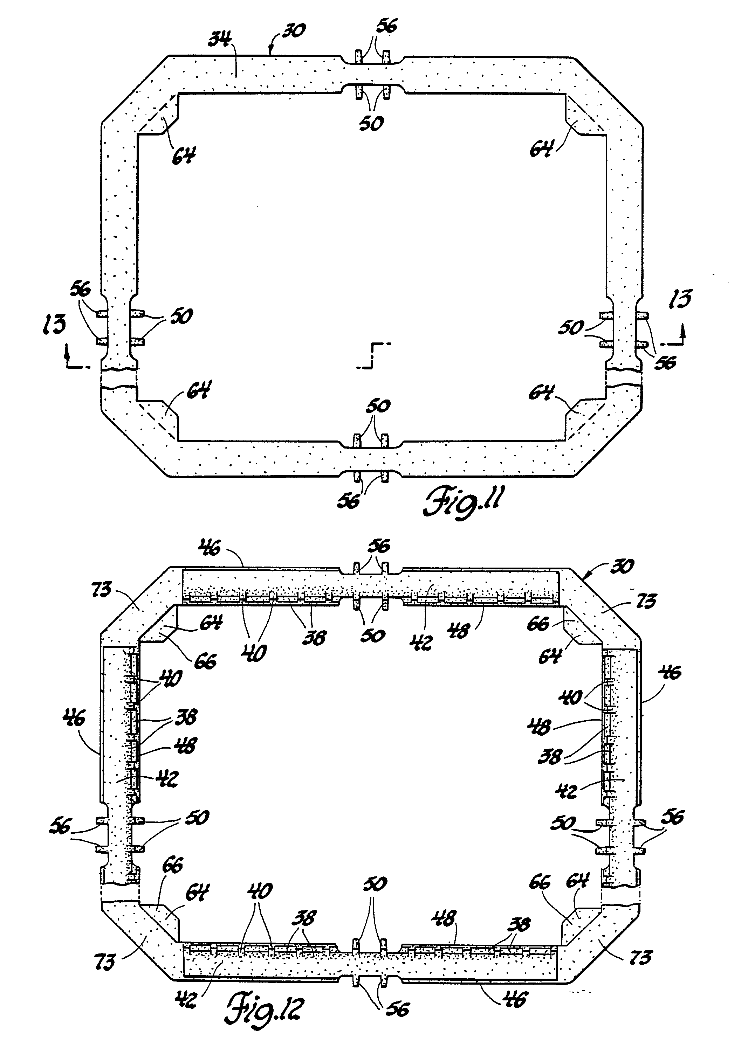

The assembly procedure of the first preferred embodiment is shown in FIGURES 7 to 10. A partially cutaway perspective view of this preferred embodiment is also shown in FIGURE 2. FIGURE 7 shows locating ring 30, TAB integrated circuit module 10 with external leads 12 exposed, and retainer ring 32 in a pre-assembled position. When locating ring 30 is pushed down onto module 10 and retainer ring 32, the contoured end 42 and latches 50 and 56 perform the necessary forming action on the external leads 12 by wrapping the external leads 12 around contoured end 42 on the external surface of locating ring 30. As locating ring 30 is pushed down fully into the retainer ring 32, locating ring 30 is locked into retainer ring 32 by the engagement of latches 56 and 50 with the recessed areas 58 and 52, respectively. This is shown in FIGURE 8. FIGURE 9 is a front view of an assembled integrated circuit package in which the locating ring and the retainer ring are snapped together with the TAB integrated circuit module nested in between. It is to be noted that the locking action provided between the latches and the recesses, i.e., latches 50 and 56 on locating ring 30 and recesses 52 and 58 on module 10 and retainer ring 32, may be released by pulling the retainer ring and the locating ring together upward. A TAB integrated circuit module I0 having its external leads I2 formed into a desirable shape such that they may be soldered down to a circuit board is shown in FIGURE I0. It is also to be noted that during the process of assembly (FIGURE 7), where the locating ring 30 is pushed down into the retainer ring 32, the advancement of locating ring 30 is stopped when surface 66 on stops 64 on the locating ring contacts the corresponding surface of recesses 20 on the TAB integrated circuit module I0. The further advancement of module I0 and locating ring 30 into retainer ring 32 is stopped when a stop 73 located at each corner of locating ring 30 engages a stop 70 located at each corner of retainer ring 32 on surface 68.

FIGURE II shows a plan view of locating ring 30. Note the position of latches 50 and 56 which are located on the interior wall and the exterior wall respectively. FIGURE I2 is a bottom view of retainer ring 30. Note the positions of recessed areas 38 for the external leads and latches 40 separating the recessed areas. FIGURE I3 is a cross-sectional view taken substantially along line I3-I3 in FIGURE II. FIGURE I4 shows a plan view of retainer ring 32. Note the recessed areas 58 for the engagement of latches 56 located on locating ring 30. FIGURE I5 is a cross-sectional view taken along line I5-I5 in FIGURE I4.

While the invention has been described in terms of two preferred embodiments thereof, it is to be appreciated that those skilled in the art will readily apply these teachings to other possible variations of the invention claimed herein.

## Claims

I. An integrated circuit package containing an integrated circuit module (I0) having closely-spaced external leads (I2) subject to unwanted deformation before use, in which package a lead-forming and protective member (30) is affixed to said package over said leads (I2) and co-operates with conformations (20) on said module (I0) to retain the leads - (I2) in predetermined disposition relative to one another, said protective member (30) having a surface (48) facing the module (I0) and projections - (40) on that surface (48) for maintaining the leads - (I2) mutually separated, characterised in that said external leads (I2) contact at least one edge of that surface (48) and are closely wrapped around an adjacent end (42) of said protective member (30) to conform with and to engage the adjacent end (42) of the protective member (30) to enhance resistance to unwanted deformation of said leads (I2).

2. An integrated circuit package according to claim I, characterised in that said leads (I2) are wrapped around said end (42) of said protective member (30) onto an opposite surface (46) of said member (30), effective to provide a physical engagement between said protective member (30) and said package leads (I2) such that said protective member (30) not only shapes said package leads (I2) into a predetermined conformation but helps retain the leads (I2) in that conformation once so formed; and said integrated circuit package includes a supplementary member (32) removably mounted on said protective member (30 and having on the body thereof an inner surface (60) opposing and frictionally engaging the ends of said formed package leads (I2), so as to shield the ends of said formed package leads (I2) from unwanted deformation and damage.

3. An integrated circuit package according to claim 2, characterised in that the protective member is a locating ring (30) comprising an annular orthogonal body member, a plurality of said projections (40) on said inner surface (48) of said body member providing recesses (38) for the leads (I2), which leads (I2) nest in the recesses (38); the supplementary member is a retainer ring (32) comprising a similar annular orthogonal body member having said inner surface (60) opposing and frictionally engaging the free ends of said leads (I2); and said retainer ring (32) includes a stop (70) at each inner corner thereof which engages a corresponding stop (73) on each corner of the locating ring (30) so that said retainer ring (32) may be removably mounted on the outer surface (46) of said locating ring (30) to completely shield the free ends of said leads (I2) from unwanted deformation and damage.

*Fig.1*

*Fig.2*

Fig.3

Fig.4

Fig.5

Fig.6

Fig.7

Fig.8

Fig.9

Fig.10

Fig.11

Fig.12

*Fig.13*

*Fig.14*

*Fig.15*